# EUROPEAN PATENT SPECIFICATION

(11) **EP 0 271 346 B1**
(45) Date of publication and mention of the grant of the patent: **03.05.1995**
(21) Application number: 87310889.8
(22) Date of filing: 10.12.1987
(51) Int. Cl.: H01L 29/47, H01L 29/80

(54) **Transistor employing composite of semiconductor material and conductive material**
Transistor mit Zusammensetzung aus Halbleitermaterial und aus leitendem Material
Transistor comportant composé de matériau semi-conducteur et de matériau conducteur

(30) Priority: 11.12.1986 US 941478; 11.12.1986 US 940371
(43) Date of publication of application: 15.06.1988
(73) Proprietor: GTE LABORATORIES INCORPORATED, Wilmington Delaware 19801 (US)
(72) Inventor: Ditchek, Brian M., Milford, MA 01775 (US); Sichel, Enid K., Lincoln, MA 01773 (US); Cogan, Adrian I., San Jose CA 95129 (US); Bloss III, Walter L., Palos Verdes, CA 90274 (US)
(74) Representative: Bubb, Antony John Allen

(56) References cited:
- US-A- 4 371 406
- APPLIED PHYSICS LETTERS, vol. 49, no. 24, 15th December 1986, pages 1656-1658,American Institute of Physics, New York, US; B.M. DITCHEK et al.: "Si-TASi2 insitu junction eutectic composite diodes"
- IDEM
- IEEE TRANSACTIONS ON ELECTRON DEVICES,VOL. ED-27,NO. 6,JUNE 1980, PAGES 1128-1141
- IEEE ELECTRON DEVICE LETTERS,EDL-5,NO. 7,JULY 1984,PAGES 270-272

## Description

This invention relates to semiconductor devices. More particularly, it is concerned with devices employing composites of semiconductor material and conductive materials that form a eutectic with the semiconductor material.

In conventional planar semiconductor device technology the flow of current between the source and drain electrodes of a field effect transistor (FET) is controlled by applying a gate voltage to its gate electrode. The gate voltage increases or decreases the width of the depletion layer of the gate region between the source and the drain, and thus alters the effective resistance of the device. That is, an FET is basically a voltage-controlled resistor. In order to reduce significantly the current passing between the source and the drain, the gate voltage should be able to increase the width of the depletion layer to a dimension comparable to the total width of the current path. Thus, for practical purposes, the current channel of an FET fabricated by conventional planar technology is limited to about 1 to 10 micrometers. These physical limitations of the device elements limit the amount of current which can be controlled.

There is known, for example, from IEEE Electron Device Letters Vol. EDL-5, No. 7, July 1984, pages 270-272 a transistor comprising:
a body including a matrix of single crystal semiconductor material having disposed therein an array of rods of conductive material forming rectifying barriers at the interfaces of the rods and the matrix of semiconductor material, said rods being generally parallel to each other.
a source contact member and a drain contact member respectively in ohmic contact with the matrix of semiconductor material at opposite surfaces thereof extending parallel to said rods; and
a control contact member in ohmic contact with said array of rods at one end thereof, whereby, in use, current flows from the source contact member to the drain contact member between the rods and depletion zones established around the rods by biasing potential applied to said control contact.

This known device is a so-called 'permeable base transistor' wherein the array of rods forms a two dimensional grating extending in a single plane so that the rods and the control contact form the permeable base. Two such gratings formed in the semiconductor matrix are each separately connected to a corresponding base contact to form a dual grating structure.

Such a device is a development of the permeable base transistor discussed in more detail in IEEE TRANSACTIONS ON ELECTRON DEVICES Vol. ED-27, No. 6, June 1980 pages 1128-1141, which also describes the distinctions between this device and an FET.

Reference is also made to US-A-4371406 which describes a semiconductor device having a body including a matrix of single crystal semiconductor material having disposed therein a three dimensional array of individual rods of conductive material.

It is an object of the present invention to form an FET having improved current handling characteristics.

In accordance with the invention this object is achieved in a transistor device as outlined above, in that said rods extend individually in a three dimensional array from a first major surface of said body perpendicular to the longitudinal axes of said rods to a second major surface opposite to the first and that said control contact member is applied to said first major surface to make ohmic contact with ends of the three aimensional array of rods that are exposed at said first major surface, whereby said control contact member and the three dimensional array of rods form the single gate of a field effect transistor and the said matrix of semiconductor material forms a three dimensional channel thereof.

### In the drawings:

Figure 1 is a schematic representation of a perspective view taken in cross-section of a fragment of a body which includes a matrix of semiconductor material having conductive rods disposed therein;
Figures 2A-2E are elevational views in cross-section illustrating various stages in the process of fabricating an FET in accordance with the present invention; and
Figure 3 is a schematic representation in perspective of an FET in accordance with the present invention.

In the figures the various elements are not drawn to scale. Certain dimensions are exaggerated in relation to other dimensions in order to present a clearer understanding of the invention.

For a better understanding of the present invention, together with other and further objects, advantages, and capabilities thereof, reference is made to the following disclosure and appended claims in connection with the above-described drawings.

In fabricating devices in accordance with the present invention, a charge containing the constituents of a eutectic composition of a semiconductor material and a conductive material is prepared. Any of several eutectic systems may be utilized in which the semiconductor phase is the matrix phase and the conductive material is the minor phase. These systems may be, for example, of the form Ge-MGe₂, Si-MSi₂, and GaAs-MAs, where M is a metal. A charge containing the constituents in proper proportions to the eutectic composition of the semiconductor material and the conductive compound is melted in a suitable crucible and solidified unidirectionally.

More specifically, a Czochralski crystal growth technique is employed in which a single crystal seed of the semiconductor material is lowered into contact with the molten surface of the charge, and the seed is pulled upward. A boule consisting of a composite of the semiconductor material and the conductive material that forms a eutectic with the semiconductor material is produced in which the semiconductor material is in the form of a single crystal matrix with rods of the conductive material disposed in the matrix. The matrix of semiconductor material is of the same crystal orientation as the seed crystal and the rods extend generally parallel to the direction of pulling.

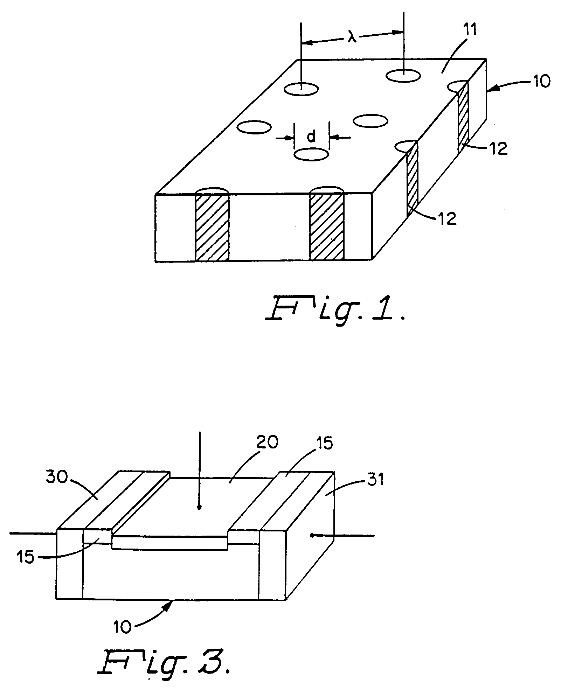

Fig. 1 illustrates a fragment of a section or a body 10 cut from a boule grown as above. The body consists essentially of a matrix of semiconductor material 11 and an array of rods 12 of the conductive material which forms the eutectic composition with the semiconductor material. As illustrated in Fig. 1, the upper and lower major surfaces of the body 10 are a result of cutting the boule transverse to the direction of pulling of the seed crystal. The side surfaces are formed by cuts parallel to the rods 12. Each rod 12 extends perpendicularly from the upper major surfaces to the lower major surface. The rods 12 are not necessarily of perfect circular cross-section nor are they necessarily perfectly parallel. The rods 12 are, however, each individual elements and do not interconnect, and the semiconductor matrix 11 is entirely interconnected and surrounds each of the individual rods.

The semiconductor material of the melt is appropriately doped with conductivity type imparting material of either N or P-type so that Schottky barriers are formed between the conductive rods 12 and the semiconductor matrix 11. The carrier concentration in the semiconductor material is from 10¹⁴ to 10¹⁶ cm⁻³. The volume fraction of the rods 12 in the body 10 should be between 0.5% and 35%. The inter-rod spacing of a composite formed by eutectic solidification is given by λ ²v = constant, where λ is the average inter-rod spacing, v is the growth rate, and the constant is a characteristic of the particular eutectic system. The rod diameter (d) is related to the inter-rod spacing (λ) by the volume fraction of the rods as determined by the eutectic phase diagram of the particular eutectic system. For suitable device structures the inter-rod spacing (λ) should be between 1 and 50 micrometers, and the rod diameter (d) should be between 0.1 and 15 micrometers.

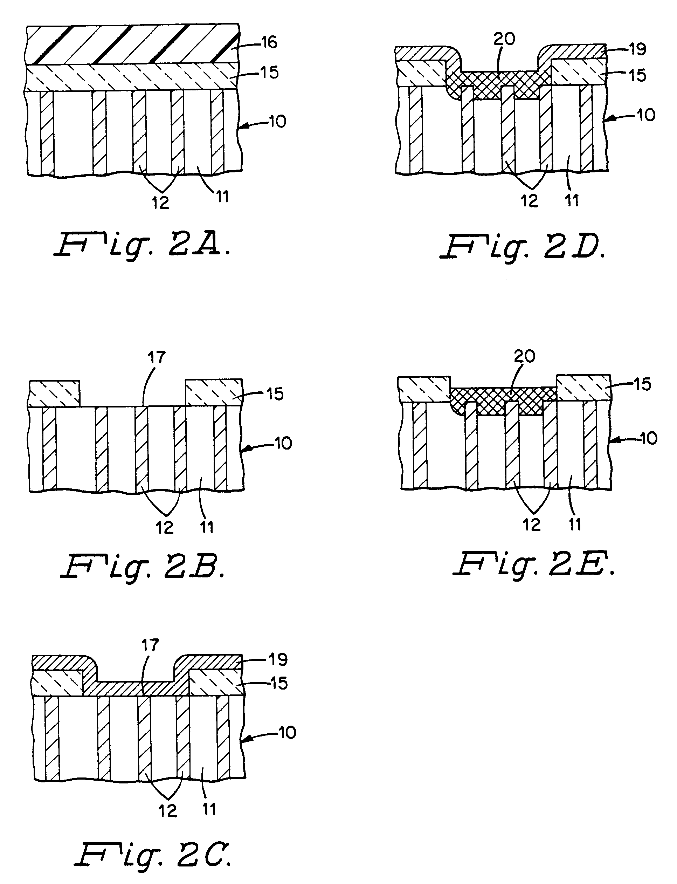

Figs. 2A - 2E illustrate stages in the fabrication of a device from a body 10 as illustrated in Fig. 1 of a matrix 11 of semiconductor material having disposed therein an array of conductive rods 12. For purposes of discussion the semiconductor matrix 11 is of single crystal silicon with conductive rods 12 of tantalum silicide (TaSi₂) grown from a Si-TaSi₂ eutectic composition. Examples of other suitable Si-silicide eutectic systems are Si-tungsten silicide, Si-niobium silicide, Si-zirconium silicide, and Si-chromium silicide.

After suitable polishing of the surfaces of the body 10 to remove surface damage, the body is treated in wet oxygen to form an adherent layer of silicon oxide 15 on the upper major surface as illustrated in Fig. 2A. A standard photoresist material 16 is deposited on the silicon oxide coating 15. By employing known photolithographic masking and etching techniques an opening is formed in the photoresist layer 16 and then an opening 17 is etched in the oxide layer 15. The photoresist material is then removed. As illustrated in Fig. 2B the end surfaces of several of the conductive rods 12 encircled by the silicon matrix 11 are exposed at the uncovered area of the upper major surface.

A film 19 of a suitable metal which forms a conductive compound with silicon, specifically cobalt, is deposited over the layer of silicon oxide 15 and also over the surface of the body at the opening 17 as illustrated in Fig. 2C. The body is then subjected to a rapid thermal annealing treatment by heating at a temperature of about 800°C for about 12 seconds to cause the cobalt in contact with silicon to react and form a conductive member 20 of cobalt disilicide as illustrated in Fig. 2D. The cobalt over the silicon oxide does not react and remains as cobalt. This unreacted cobalt is removed by a suitable chemical etch which attacks the cobalt but does not significantly affect the cobalt disilicide.

In the resulting structure as illustrated in Fig. 2E the cobalt disilicide contact member 20 forms an ohmic contact with the ends of several of the TaSi₂ rods 12. The interface of the cobalt disilicide contact member 20 with the silicon of the matrix 11 is a Schottky rectifying barrier. The rectifying barrier formed between the contact member 20 and the semiconductor matrix 11 should have a barrier potential which is equal to or higher than the barrier potential of the rectifying barrier between the conductive rods 12 and the semiconductor matrix 11. Platinum silicide has a high potential barrier with N-type silicon and yttrium silicide has a high potential barrier with P-type silicide. Other silicide-forming metals which may be used include nickel, titanium, tantalum, tungsten, and molybdenum.

Fig. 3 illustrates an FET fabricated from the structure as illustrated in Fig. 2E. The contact member 20 in ohmic contact with several rods serves as the gate contact member. Ohmic contacts 30 and 31 are made to opposite side surfaces of the body 10 to serve as source and drain contact members, respectively. Current from the source contact 30 to the drain contact 31 flows through the channel region of the silicon matrix which underlies the gate contact member 20. The channel region is interspersed with the conductive rods which contact the gate contact 20. Since the interfaces between the rods and the silicon matrix are Schottky rectifying junctions, a depletion zone is produced in the silicon adjacent to each of the rods by biasing potential applied to the gate contact 20. Each depletion zone extends from the interface of the rod with the matrix laterally outward into the matrix. Due to the lack of mobile current carriers in these zones, they have a very high resistance relative to the resistance of the normally-doped silicon of the matrix. Thus, the effective channel for current flow is determined by the spacing between the depletion zones.

The size of the depletion zones is determined primarily by the carrier concentration in the silicon and the magnitude of the bias voltage applied to the gate contact 20. The carrier concentration of the silicon of the matrix is designed such that without a bias voltage applied to the conductive rods, the depletion zones are small, consuming a sufficiently small volume of the channel region so as to have little or no effect on the resistivity of the composite and thus of current flow from the source to the drain. The growth rate (v) at which the composite is pulled from the molten charge is chosen to produce inter-rod spacing (λ) such that the application of a suitable reverse bias voltage to the rods is sufficient to enlarge the depletion zones around the rods such that the depletion zones extend across the channel. The channel is thereby closed, effectively "pinching off" current flow between the source and drain and switching the device off.

A significant distinction between an FET as described and a conventional planar FET is the magnitude of the channel. In the eutectic composites as discussed hereinabove the rods are continuous from the top surface to the bottom surface of the body. Thus, the rectifying junctions extend through the entire thickness of the body producing a three-dimensional volume of semiconductor material to be controlled, which is significantly greater than the volume of the channel in a conventional planar FET. Since the thickness of the composite body may be orders of magnitude greater than the channel of a conventional planar FET, it is capable of switching currents which are orders of magnitude greater.

As an example of a body suitable for devices of the invention, Si-TaSi₂ eutectic composites were grown directly from a melt in a Czochralski crystal growth furnace in accordance with Czochralski crystal growth techniques, A charge of silicon and tantalum was placed in a quartz crucible with a graphite susceptor. The tantalum was 5.5 % by weight of the charge, providing the mole ratio of silicon to tantalum in the Si-TaSi₂ eutectic composition. The charge was doped with phosphorus. After rf heating the charge to above the eutectic temperature and obtaining charge homogenization, a (111) orientation silicon seed was lowered onto the melt surface. Composite boules were pulled from the melt at a growth rate (v) of 20cm/h in a flowing argon atmosphere. The resulting boule was approximately 2.5 cm in diameter and 12 cm in length. The silicon matrix phase was of single crystal (111) orientation and was free of grain boundaries. The boule was 2% by volume of conductive, metallic, TaSi₂ rods. At a transverse-cut major surface the composite contained 1.6 x 10⁶ TaSi₂ rods/cm² with an average rod diameter (d) of 1.2 micrometers. The average inter-rod spacing (λ) was 7.9 micrometers. The carrier concentration in the silicon matrix as determined by Hall measurements varied from 1.1 x 10¹⁵ cm⁻³ at one end of the boule to 1.8 x 10¹⁵ cm⁻³ at the opposite end. The electron mobility in the matrix was approximately 925 cm²/V-sec.

In order to verify the suitability of the rectifying junctions of such a structure for the gate electrode of an FET, diodes were fabricated from 500 micrometer thick slices of the boule. The slices were polished using colloidal silica to remove damaged surface material. A 0.2 micrometer thick silicon oxide coating was grown on the surfaces. The silicon oxide coating was covered with a photoresist layer, and using standard photolithographic and etching techniques 127 micrometer diameter openings were made in the oxide coating. The photoresist was removed, and a layer of cobalt 70 nanometres (700 angstroms) thick was deposited over the silicon oxide layer and the exposed surfaces of the slice at the openings in the silicon oxide layer. The slice was treated by rapid thermal annealing at a temperature of 800°C for 12 seconds. As explained hereinabove, the cobalt reacted with the exposed silicon at the openings in the silicon oxide coating to form cobalt disilicide contacts. The unreacted cobalt overlying the silicon oxide was removed by etchings in an HNO₃ solution. The cobalt disilicide provided ohmic metallic contacts to the exposed ends of the TaSi₂ rods while forming Schottky barriers with the silicon of the matrix. The Schottky barriers between the cobalt disilicide and the silicon have a higher barrier potential than the Schottky barriers between the TaSi₂ rods and silicon. An ohmic contact was formed adjacent to the edge of the body of each device by etching away silicon oxide and then depositing and alloying a gold-antimony film.

Based on the area of the cobalt disilicide contact member and the rod density, the effective region of a diode device contains 190 rods. For a 500 micrometer thick device the total junction area is 3.6 x 10⁻³ cm². This area is approximately thirty times the area of contact of the cobalt disilicide member to the silicon matrix. Since cobalt disilicide provides a slightly higher Schottky barrier to silicon than does tantalum disilicide (0.64eV versus 0.59eV) the contribution of the cobalt disilicide-silicon junction to the current-voltage and capacitance-voltage characteristics is negligible.

The current-voltage and capacitance-voltage characteristics of the diodes were analyzed. The diodes were ideally low in leakage and the breakdown voltage exceeded 10 volt. Breakdown was "soft" and occurred at about 30 volts. Analysis of the current-voltage characteristics based on the Si-TaSi₂ junction area indicated a Schottky barrier potential of 0.62 eV. The ideality factor of the device was nearly ideal and comparable to conventional planar diodes. The capacitance-voltage analysis indicated that the junctions operated like cylindrical junctions, as opposed to planar junctions. The capacitance values verify that the entire junction area was contributing to the capacitance.

Electron beam induced current (EBIC) techniques were also used to study the junctions and the eutectic composite. The results indicated that with a 10 volt reverse bias gate voltage, a value much less than the breakdown voltage, the depletion zone around each rod can be enlarged from 0.8 micrometers to 2.5 micrometers. At 2.5 micrometers the depletion zone volume fraction of the composite is 45%, nearly enough to cause "pinch off." Resistivity measurements indicate that increasing the volume fraction of depleted material from 5% to 10% is sufficient to increase the resistivity of the device by a factor of 7. The EBIC measurement technique also verified that the rods extend completely through slices 1270 micrometers thick.

Thus, devices can be fabricated from eutectic composites produced by employing Czochralski techniques to directionally solidify a semiconductor material and a conductive compound of the semiconductor material and a metal which form a suitable eutectic composition. A three-dimensional or bulk structure is thus provided for the fabrication of an FET in which the gate structure is an array of Schottky barriers with the bulk semiconductor material. Such a device is capable of controlling large amounts of current.

## Claims

1. A transistor comprising:
a body including a matrix (11) of single crystal semiconductor material having disposed therein an array of rods (12) of conductive material forming rectifying barriers at the interfaces of the rods (12) and the matrix (11) of semiconductor material, said rods (12) being generally parallel to each other.
a source contact member (30) and a drain contact member (31) respectively in ohmic contact with the matrix (11) of semiconductor material at opposite surfaces thereof extending parallel to said rods; and
a control contact member (20) in ohmic contact with said array of rods (12) at one end thereof, whereby, in use, current flows from the source contact member (30) to the drain contact member (31) between the rods (12) and depletion zones established around the rods (12) by biasing potential applied to said control contact,
characterised in that said rods (12) extend individually in a three dimensional array from a first major surface of said body perpendicular to the longitudinal axes of said rods to a second major surface opposite to the first and that said control contact member (20) is applied to said first major surface to make ohmic contact with ends of the three dimensional array of rods that are exposed at said first major surface, whereby said control contact member (20) and the three dimensional array of rods (12) form the single gate of a field effect transistor and the said matrix of semiconductor material forms a three dimensional channel thereof.

2. A field effect transistor in accordance with Claim 1 characterised in that said control contact member (20) is in rectifying contact with said semiconductor material of said matrix (11) at said first major surface of the body.

3. A field effect transistor in accordance with Claim 1 or 2 characterised in that the conductive material of said rods (12) is a conductive compound of a first metal and the semiconductor material of the matrix (11) or of a first metal and a constituent element of the semiconductor material.

4. A field effect transistor in accordance with Claim 3 characterised in that the said conductive compound and the semiconductor material are the constituents of a eutectic composition; and the mole ratio of semiconductor material to the first metal in the matrix and array of rods is approximately equal to the mole ratio of the semiconductor material to the first metal in the eutectic composition of the semiconductor material and the conductive compound.

5. A field effect transistor in accordance with Claim 3 or 4 characterised in that the semiconductor material is silicon, germanium, or a III-V compound semiconductor material; and that said first metal is tantalum, tungsten, niobium, zirconium, or chromium.

6. A field effect transistor in accordance with Claim 2 or any one of Claim 3-5 as appended thereto characterised in that said control contact member (20) is adherent to a portion of said first major surface and is in low resistance ohmic contact with the plurality of rods at said ends thereof, that said source contact member (30) is in contact with the matrix of semiconductor material at a first side surface of the body lying normal to said first and second major surfaces and parallel to said rods (12); and that said drain contact member (31) is in contact with the matrix (11) of semiconductor material at a second side surface of the body lying parallel to said first side surface.

7. A field effect transistor in accordance with any one of Claim 3-6 characterised in that the volume fraction of the array of rods (12) of the conductive compound in the body is from 0.5 to 35 percent.

8. A field effect transistor in accordance with any one of Claims 5-7 characterised in that said control contact member (20) is a conductive compound of cobalt, platinum, yttrium, nickel, titanium, tantalum, tungsten, or molybdenum, and the semiconductor material of the matrix.

9. A field effect transistor in accordance with any one of Claims 1-8 characterised in that the diameter of each of said rods is from 0.1 to 15 micrometers; and the spacing between adjacent rods is from 1 to 50 micrometers.

## Patentansprüche

1. Transistor, welcher umfaßt:
einen Körper, der eine Matrix (11) aus einkristallinem Halbleitermaterial enthält, in dem eine Anordnung aus Stabchen (12) von leittähigem Material angeordnet sind, die gleichrichtende Sperrschichten an der Zwischenfläche der Stäbchen (12) mit der Matrix (11) aus Halbleitermaterial bilden, wobei die Stäbchen (12) allgemein parallel zueinander sind;
ein Source-Kontaktglied (30) und ein Drain-Kontaktglied (31), die jeweils in ohm'schem Kontakt mit der Matrix (11) aus Halbleitermaterial stehen, an einander entgegengesetzt liegenden Flächen der Matrix, die sich parallel zu den Stäbchen erstrecken; und
ein Steuerkontaktglied (20) in ohm'schem Kontakt mit der Anordnung von Stäbchen (12) an einem Ende derselben, wodurch im Gebrauch Strom von dem Source-Kontaktglied (30) zu dem Drain-Kontaktglied (31) zwischen den Stäbchen (12) fließt und Verarmungszonen um die Stäbchen (12) durch an den Steuerkontakt angelegtes Vorspannungspotential eingerichtet werden,
**dadurch gekennzeichnet**, daß die Stäbchen (12) sich in einer dreidimensionalen Anordnung einzeln von einer ersten zur Längsachse der Stäbchen senkrechten Hauptfläche des Körpers zu einer zweiten der ersten Hauptfläche gegenüberliegenden Hauptfläche erstrecken, und daß das Steuerkontaktglied (20) an die erste Hauptfläche angelegt ist, um einen ohm'schen Kontakt mit den an der ersten Hauptfläche freigelegten Enden der dreidimensionalen Stabchen-Anordnung herzustellen, wodurch das Steuer-Kontaktglied (20) und die dreidimensionale Anordnung von Stäbchen (12) das einzige Gate eines Feldeffekt-Transistors bilden und die Matrix des Halbleitermaterials einen dreidimensionalen Kanal desselben bildet.

2. Feldeffekt-Transistor nach Anspruch 1, **dadurch gekennzeich****net,** daß das Steuerkontaktglied (20) sich an der ersten Hauptfläche des Körpers in gleichrichtendem Kontakt mit dem Halbleitermaterial der Matrix (11) befindet.

3. Feldeffekt-Transistor nach Anspruch 1 oder 2, **dadurch** **gekennzeichnet,** daß das leitende Material der Stäbchen (12) eine leitende Verbindung aus einem ersten Metall und dem Halbleitermaterial der Matrix (11) oder aus einem ersten Metall und einem konstituierenden Element des Halbleitermaterials ist.

4. Feldeffekt-Transistor nach Anspruch 3, **dadurch gekennzeich****net**, daß die leitende Verbindung und das Halbleitermaterial die Bestandteile einer eutektischen Masse sind; und daß das Molverhältnis des Halbleitermaterials zum ersten Metall in der Matrix und in der Anordnung von Stäbchen annähernd gleich dem Molverhältnis des Halbleitermaterials zu dem ersten Metall in der eutektischen Masse aus Halbleitermaterial und der leitenden Verbindung sind.

5. Feldeffekt-Transistor nach Anspruch 3 oder 4, **dadurch** **gekennzeichnet,** daß das Halbleitermaterial Silizium, Germanium oder ein III/V-Verbindungs-Halbleitermaterial ist, und daß das erste Metall Tantal, Wolfram, Niob, Zirkon oder Chrom ist.

6. Feldeffekt-Transistor nach Anspruch 2 oder einem der Ansprüche 3 - 5 in Abhängigkeit von diesem, **dadurch gekenn****zeichnet**, daß das Steuerkontaktglied (20) an einem Abschnitt der ersten Hauptfläche anhängt und in einem ohm'schen Kontakt mit niedrigem Übergangs-Widerstand mit der Vielzahl von Stäbchen an deren Enden steht, und daß das Source-Kontaktglied (30) sich in Kontakt mit der Matrix des Halbleitermaterials an einer ersten Fläche des Körpers befindet, die senkrecht zu der ersten und der zweiten Hauptfläche und parallel zu den Stäbchen (12) liegt; und daß das Drain-Kontaktglied (31) sich in Kontakt mit der Matrix (11) aus Halbleitermaterial befindet an einer zweiten Seitenfläche des Körpers, die parallel zur ersten Seitenfläche liegt.

7. Feldeffekt-Transistor nach einem der Ansprüche 3-6, **dadurch** **gekennzeichnet,** daß der Volumenanteil der Anordnung von Stäbchen (12) aus der leitenden Verbindung in dem Körper von 0,5 bis 35% liegt.

8. Feldeffekt-Transistor nach einem der Ansprüche 5-7, **dadurch** **gekennzeichnet,** daß das Steuer-Kontaktglied (20) eine leitende Verbindung von Kobalt, Platin, Yttrium, Nickel, Titan, Tantal, Wolfram oder Molybdän mit dem Halbleitermaterial der Matrix ist.

9. Feldeffekt-Transistor nach einem der Ansprüche 1-8, **dadurch** **gekennzeichnet,** daß der Durchmesser jedes Stäbchens zwischen 0,1 bis 15 »m liegt und daß der Abstand zwischen benachbarten Stäbchen von 1 bis 50 »m beträgt.

## Revendications

1. Transistor constitué de:
un corps comprenant une matrice (11) d'un seul cristal semi-conducteur dans lequel est disposé un agencement de tiges (12) de matériau conducteur formant des barrières de redressement aux interfaces des tiges (12) et de la matrice (11) de matériau semi-conducteur, lesdites tiges (12) étant disposées en lignes parallèles
un élément de contact de source (30) et un élément de contact de drain (31) respectivement en contact ohmique avec la matrice de matériau semi-conducteur aux surfaces opposées de ladite matrice et parallèle auxdites tiges; et
un élément de contact de commande (20) en contact ohmique avec ledit agencement de tiges (12) à une extrémité de celui-ci, de telle sorte que, en utilisation, le courant passe de l'élément de contact de source (30) à l'élément de contact de drain (31) entre les tiges (12) et les zones de déplétion établies autour des tiges (12) en polarisant le potentiel appliqué audit contact de commande,
caractérisé en ce que lesdites tiges (12) s'étendent individuellement dans un agencement tridimensionnel à partir d'une première surface principale dudit corps perpendiculairement aux axes longitudinaux desdites tiges jusqu'à une deuxième surface principale opposée à la première et en ce que ledit élément de contact de commande (20) est appliqué à ladite première surface principale pour établir un contact ohmique avec les extrémités de l'agencement tridimensionnel de tiges qui sont exposées à ladite première surface principale, de telle sorte que ledit élément de contact de commande et l'agencement tridimensionnel de tiges (12) forment la porte unique d'un transistor à effet de champ et que ladite matrice de matériau semi-conducteur forme un canal tridimensionnel de celui-ci.

2. Transistor à effet de champ selon Revendication 1, caractérisé en ce que ledit élément de contact de commande (20) est en contact de redressement avec ledit matériau semi-conducteur de ladite matrice (11) à ladite première surface principale du corps.

3. Transistor à effet de champ selon Revendication 1 ou 2, caractérisé en ce que le matériau conducteur desdites tiges (12) est un composé conducteur d'un premier métal et le matériau semi-conducteur de la matrice (11) ou d'un premier métal et un élément constitutif du matériau semi-conducteur.

4. Transistor à effet de champ selon Revendication 3 caractérisé en ce que ledit composé conducteur et le matériau semi-conducteur sont les éléments constitutifs d'une composition eutectique; et en ce que le rapport molaire du matériau semi-conducteur du premier métal de la matrice et de l'agencement de tiges est approximativement égal au rapport molaire du matériau semi-conducteur au premier métal dans la composition eutectique du matériau semi-conducteur et du composé conducteur.

5. Transistor à effet de champ selon Revendication 3 ou 4 caractérisé en ce que le matériau semi-conducteur est du silicium, du germanium ou un matériau semi-conducteur composé III-V; et en ce que ledit premier métal est du tantale, du tungstène, du niobium, du zirconium ou du chrome.

6. Transistor à effet de champ selon Revendication 2 ou l'une quelconque des revendications 3-5 qui lui sont annexées, caractérisé en ce que ledit élément de contact de commande (20) adhère à une partie de ladite première surface principale et est en contact ohmique à faible résistance avec la pluralité de tiges auxdites extrémités de celles-ci, et en ce que ledit élément de contact de source (30) est en contact avec la matrice de matériau semi-conducteur à une première surface latérale du corps perpendiculaire auxdites première et deuxième surfaces principales et parallèle auxdites tiges (12); et en ce que ledit élément de contact de drain (31) est en contact avec la matrice (11) de matériau semi-conducteur à une deuxième surface latérale du corps parallèle à ladite première surface latérale.

7. Transistor à effet de champ selon l'une quelconque des Revendications 3-6, caractérisé en ce que la fraction volumique de l'agencement de tiges (12) du composé conducteur dans le corps est de 0,5 à 35%.

8. Transistor à effet de champ selon l'une quelconque des Revendications 5-7 caractérisé en ce que ledit élément de contact de commande (20) est un composé conducteur de cobalt, platine, yttrium, nickel, titane, tantale, tungstène ou molybdène, et le matériau semi-conducteur de la matrice.

9. Transistor à effet de champ selon l'une quelconque des Revendications 1-8 caractérisé en ce que le diamètre de chacune desdites tiges est de 0,1 à 15 microns et l'espacement entre tiges adjacentes de 1 à 50 microns.
